# EUROPEAN PATENT APPLICATION

(11) **EP 4 455 376 A1**
(43) Date of publication of application: **30.10.2024**
(21) Application number: 22911861.7
(22) Date of filing: 20.12.2022
(51) Int. Cl.: C30B 31/16, C30B 31/18, H01L 21/02

(54) **METHOD FOR DOPING CARBON IN THIN FILM ON WAFER**

(30) Priority: 20.12.2021 KR 20210182550
(71) Applicant: HPSP Co., Ltd., Hwaseong-si, Gyeonggi-do 18449 (KR)
(72) Inventor: CHO, Sung Kil, Yongin-si, Gyeonggi-do 16995 (KR)
(74) Representative: von Bülow & Tamada
(86) International application number: PCT/KR2022/020849
(87) International publication number: WO 2023/121228

(57) **Abstract**

The present invention provides a method for doping carbon in a thin film on a wafer, the method comprising the steps of: arranging a thin film-formed wafer in a processing area; supplying an atmospheric gas into the processing area to bring the pressure in the processing area to a process pressure higher than atmospheric pressure; heating the processing area to bring the temperature in the processing area to a processing temperature; and supplying a source gas containing carbon to the processing area to allow the source gas to undergo a chemical reaction with the thin film under the process pressure at the process temperature, thereby injecting the carbon into the thin film.

## Description

### [Technical Field]

The present invention relates to a method for doping carbon in a thin film on a wafer in a semiconductor manufacturing process.

### [Background Art]

In general, a semiconductor manufacturing process may be largely classified into a pre-process and a post-process. The pre-process may include processes such as oxidation, deposition, exposure, etching, ion implantation, and wiring.

The deposition process may be a process of depositing a very thin layer of a desired material on a surface of a wafer. A specific method of the deposition may include chemical vapor deposition (CVD), physical vapor deposition (PVD), or atomic layer deposition (ALD). The chemical vapor deposition uses a chemical reaction to form a thin film, and the physical vapor deposition uses a physical method of forming a thin film. The atomic layer deposition uses a method of stacking atomic layers to form a very thin film. This atomic layer deposition method shows excellent step coverage together with the chemical vapor deposition.

In the deposition process, carbon may be sometimes added to improve properties of the thin film. For this purpose, a carbon gas may be co-flowed into a vacuum chamber together with a gas for forming the thin film, and react with the wafer. Adding carbon in this way may cause poor step coverage although improving other properties of the thin film. It is impossible to solve this problem even by using the atomic layer deposition. The poor step coverage may pose the greatest difficulty to a semiconductor design having a large aspect ratio.

### [Disclosure]

### [Technical Problem]

An object of the present invention is to provide a method for doping carbon in a thin film on a wafer, in which carbon may be doped in the thin film on the wafer while preventing lower step coverage of the thin film that occurs due to carbon doping.

### [Technical Solution]

According to an embodiment of the present invention, provided is a method for doping carbon in a thin film on a wafer, the method including: disposing a thin film-formed wafer in a processing area; supplying an atmospheric gas to the processing area to bring a pressure in the processing area to a processing pressure higher than atmospheric pressure; heating the processing area to bring a temperature in the processing area to a processing temperature; and supplying a source gas containing carbon to the processing area to allow the source gas to undergo a chemical reaction with the thin film at the processing pressure and the processing temperature, thereby doping carbon in the thin film.

The thin film may include any one of a silicon oxide film, a silicon nitride film, and a silicon nitride oxide film.

The processing pressure may be higher than 2 ATM.

The processing pressure may be a pressure determined within a range of 5 ATM to 20 ATM.

The processing temperature may be a temperature below a pyrolysis temperature of the source gas.

The processing temperature may be a temperature determined within a range of 400 °C to 600 °C.

The source gas may include any one of ethylene gas and propylene gas.

The atmospheric gas may include any one of hydrogen (H₂), deuterium (D₂), nitrogen (N₂), and argon (Ar) gases.

According to an embodiment of the present invention, provided is a method for doping carbon in a thin film on a wafer, the method including: disposing a thin film-formed wafer in a processing area; supplying a source gas containing carbon to the processing area; allowing a source gas to undergo a chemical reaction with the thin film in a molecular state, thus causing carbon to be chemically absorbed to the thin film; and allowing carbon to permeate into the thin film by a pressing force generated by the processing pressure.

In the allowing of the source gas to undergo the chemical reaction with the thin film in the molecular state, thus causing carbon to be chemically absorbed to the thin film, a temperature in the processing area may be maintained below a pyrolysis temperature of the source gas.

In the allowing of the source gas to undergo the chemical reaction with the thin film in the molecular state, thus causing carbon to be chemically absorbed to the thin film, a temperature in the processing area may be maintained within a range of 400 °C to 600 °C.

In the allowing of carbon to permeate into the thin film by the pressing force generated by the processing pressure, the processing pressure may be maintained to be higher than 2 ATM.

In the allowing of carbon to permeate into the thin film by the pressing force generated by the processing pressure, the processing pressure may be maintained within a range of 5 ATM to 20 ATM.

### [Advantageous Effects]

As set forth above, according to the method for doping carbon in a thin film on a wafer according to the present invention configured as above, it is possible to dope carbon in the thin film by providing the processing pressure to the processing area accommodating the thin film-formed wafer using the atmospheric gas, providing the processing temperature through the heating, and then supplying the source gas containing carbon, thereby causing the chemical reaction of the source gas with the thin film at the processing pressure and the processing temperature. As a result, the method of doping additional carbon in the thin film-formed wafer that is already made may prevent the poor step coverage of the thin film while improving the properties of the thin film by the carbon doping.

### [Description of Drawings]

FIG. 1 is a conceptual diagram of a high pressure wafer processing apparatus 100 used for performing a method for doping carbon in a thin film on a wafer according to an embodiment of the present invention.
FIG. 2 is a block diagram for explaining a control operation of the high-pressure wafer processing apparatus 100 of FIG. 1.
FIG. 3 is a flowchart for explaining the method for doping carbon in a thin film on a wafer according to an embodiment of the present invention.
FIG. 4 is a flowchart for explaining some steps of FIG. 3 in more detail.
FIG. 5 is a graph comparing carbon concentrations of the thin film doped by the method for doping carbon in a thin film on a wafer in FIG. 3.
FIG. 6 is a graph comparing wet etch depths of the thin film doped by the method for doping carbon in a thin film on a wafer in FIG. 3.

### [Best Mode]

Hereinafter, a method for doping carbon in a thin film on a wafer according to embodiments of the present invention is described in detail with reference to the accompanying drawings. Throughout the specification, components that are the same as or similar to each other are denoted by reference numerals that are the same as or similar to each other even in a different embodiment, and a description thereof is replaced by the first description.

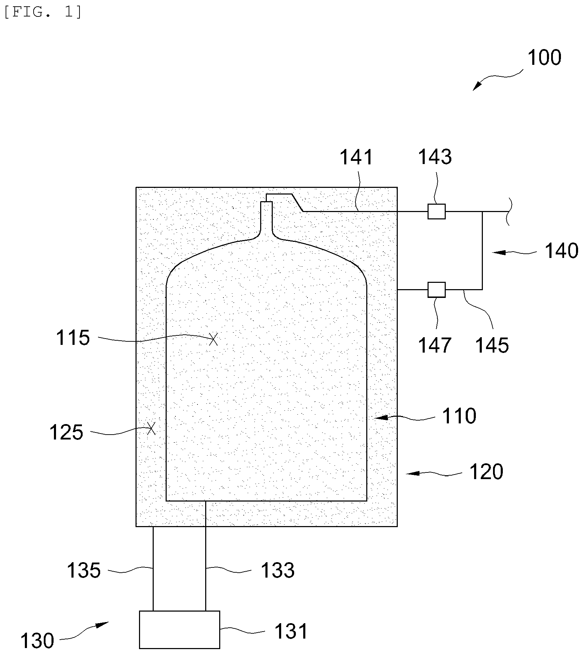

FIG. 1 is a conceptual diagram of a high pressure wafer processing apparatus 100 used for performing the method for doping carbon in a thin film on a wafer according to an embodiment of the present invention.

Referring to this drawing, the high-pressure wafer processing apparatus 100 may include an internal chamber 110, an external chamber 120, a gas supply module 130, and a gas exhaust module 140.

The internal chamber 110 may include a processing area 115 for high-pressure processing a semiconductor wafer. The internal chamber 110 may be made of a non-metallic material, for example, quartz, to reduce a possibility that contaminants (particles) occur in a processing environment. Although simplified in the drawing, a door (not shown) for opening the processing area 115 may be disposed at a lower end of the internal chamber 110. As the door descends, the processing area 115 may be opened, and the semiconductor wafer may be input into the processing area 115 while being mounted on a holder (not shown). As a heater (not shown) disposed outside the internal chamber 110 is operated, a temperature in the processing area 115 may reach several hundred degrees Celsius. The holder may be a wafer boat capable of stacking the semiconductor wafers in a plurality of layers.

The external chamber 120 may be configured to accommodate the internal chamber 110. Unlike the internal chamber 110, the external chamber 120 is free from a problem of contamination of the semiconductor wafer, and may thus be made of a metal material. The external chamber 120 may have an accommodation space 125 for accommodating the internal chamber 110. The external chamber 120 may also have a door (not shown) disposed in its lower portion. The door may descend together with the door of the internal chamber 110, and open the accommodation space 125.

The gas supply module 130 may be configured to supply a gas to the chambers 110 and 120. The gas supply module 130 may have a gas supplier 131 communicating with a utility (or gas supply facility) of a semiconductor factory. The gas supplier 131 may provide the internal chamber 110, specifically the processing area 115, with a source gas containing carbon, such as ethylene (C₂H₄) or propylene (C₃H₆) gas. The gas supplier 131 may provide the processing area 115 with an atmospheric gas such as a hydrogen, deuterium, nitrogen, or argon gas. The gas supplier 131 may provide the accommodation space 125 with a protective gas such as the nitrogen or argon gas, which is an inert gas. The protective gas injected in the accommodation space 125 may specifically fill a region of the accommodation space 125 that excludes the internal chamber 110. The gas may be injected into the processing area 115 or the accommodation space 125 through an internal gas line 133 or an external gas line 135.

The source gas, the atmospheric gas, and the protective gas may be supplied to form a high pressure higher than atmospheric pressure, for example, a high pressure ranging from several atmospheres to tens of atmospheres. In addition, when the pressure of the source gas and the atmospheric gas forms a first pressure and the pressure of the protective gas forms a second pressure, these pressures may maintain a predetermined relationship. For example, the second pressure may be set to be slightly higher than the first pressure. Such a pressure difference may prevent the source gas or the atmospheric gas from leaking from the processing area 115.

The gas exhaust module 140 may be configured to exhaust the source gas, the atmospheric gas, and the protective gas from the chamber 110 or 120. To exhaust the source gas or the atmospheric gas from the internal chamber 110, specifically the processing area 115, a gas exhaust pipe 141 may be connected to the top of the internal chamber 110. A gas discharger 143 may be installed at the gas exhaust pipe 141. The gas exhaust 143 may be a valve that regulates the exhaust of the source gas or the atmospheric gas.

A gas exhaust pipe 145 communicating with the external chamber 120 and a gas discharger 147 installed thereat may be provided to also discharge the protective gas from the external chamber 120, specifically from the accommodation space 125. These gas exhaust pipes 141 and 145 may communicate with each other, and the source gas and the atmospheric gas may thus be exhausted while diluted in the protective gas.

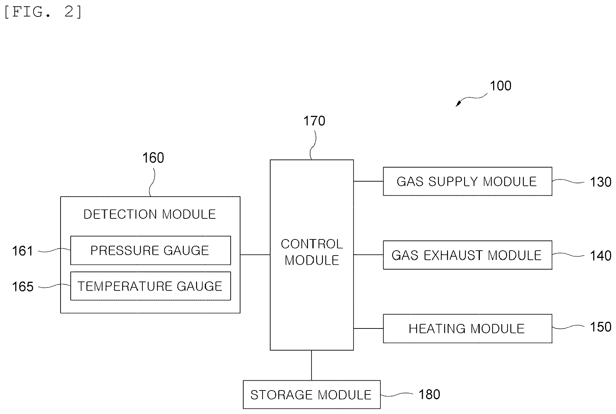

The description describes a control configuration of the high-pressure wafer processing apparatus 100 with reference to FIG. 2. FIG. 2 is a block diagram for explaining the control operation of the high-pressure wafer processing apparatus 100 of FIG. 1.

Referring to this drawing (and FIG. 1), the high-pressure wafer processing apparatus 100 may further include a heating module 150, a detection module 160, a control module 170, and a storage module 180 in addition to the gas supply module 130 and the like, described above.

The heating module 150 may include the above-mentioned heater. The heater may be disposed in the accommodation space 125. The heater may heat the atmospheric gas or the source gas to reach a processing temperature.

The detection module 160 may be configured to detect an environment of the chamber 110 or 120. The detection module 160 may include a pressure gauge 161 and a temperature gauge 165. The pressure gauge 161 and the temperature gauge 165 may be installed in each of the chambers 110 and 120.

The control module 170 may be configured to control the gas supply module 130, the gas exhaust module 140, or the like. The control module 170 may control the gas supply module 130 or the like based on a detection result of the detection module 160.

The storage module 180 may be configured to store data, programs, or the like that the control module 170 may refer to for the control. The storage module 180 may include at least one type of storage medium among a flash memory, a hard disk, a magnetic disk, and an optical disk.

According to this configuration, the control module 170 may control the gas supply module 130 or the like to perform the method for doping carbon in a thin film on a wafer according to an embodiment of the present invention.

In detail, the control module 170 may control an operation of the gas supply module 130 based on a pressure in the chamber 110 or 120 that is acquired through the pressure gauge 161. Based on the operation of the gas supply module 130, the chambers 110 and 120 may respectively be filled with the atmospheric gas and the source gas at the first pressure, and the protective gas at the second pressure.

The control module 170 may also control an operation of the heating module 150 based on a temperature in the chamber 110 or 120 acquired through the temperature gauge 165. The source gas or the atmospheric gas may reach the processing temperature based on the operation of the heating module 150.

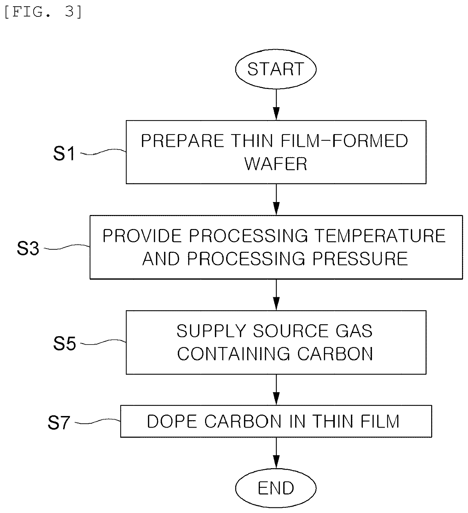

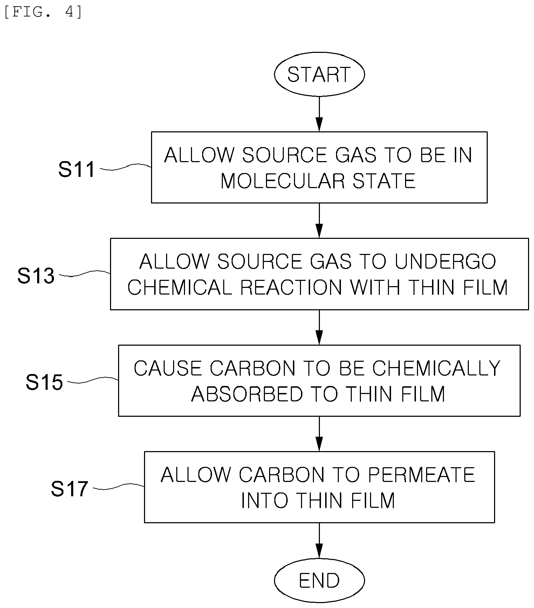

The description describes a specific method of doping carbon in a thin film on a wafer that uses the high-pressure wafer processing apparatus 100 described above with reference to FIGS. 3 and 4.

First, FIG. 3 is a flowchart for explaining the method for doping carbon in a thin film on a wafer according to an embodiment of the present invention.

Referring to this drawing (and FIGS. 1 and 2), a thin film-formed wafer may be disposed in the processing area 115 (S1). The wafer may be input into the processing area 115 while seated on the wafer boat. The thin film may be a silicon oxide film (SiO), a silicon nitride film (SiN), or a silicon nitride oxide film (SiON). This thin film may be formed through chemical vapor deposition or atomic layer deposition.

The atmospheric gas may be supplied to the processing area 115 to allow a pressure in the processing area 115 to reach a processing pressure (S3). The atmospheric gas may be supplied to the processing area 115 through the gas supply module 130 under the control of the control module 170. The atmospheric gas may be supplied at a flow rate higher than a flow rate of the source gas. Alternatively, based on a required carbon doping amount, the source gas may be supplied at a flow rate than the flow rate of the atmospheric gas.

The processing area 115 may be heated to allow the temperature in the processing area 115 to reach the processing temperature (S3). This heating may be achieved as the heating module 150 is operated under the control of the control module 170.

The source gas may be supplied to the processing area 115 through the gas supply module 130 (S5). The source gas may be a gas containing carbon, and may be ethylene gas or propylene gas, as described above. The source gas may also act as a factor in determining the processing pressure or the processing temperature. In addition, the source gas may be supplied to the processing area 115 together with the atmospheric gas.

Carbon in the source gas may be doped in the thin film (S7). For this purpose, the source gas may undergo a chemical reaction with the thin film at the processing pressure and at the processing temperature.

The thin-film formation and the carbon doping in the thin film described above may not occur simultaneously. In other words, carbon may be doped in the thin film in a state where the thin film is already formed. This carbon doping method may hardly change a preset shape (volume) of the thin film, and therefore, this method does not damage step coverage of the thin film.

The description describes more specific details of the above three steps (S3 to S7) with additional reference to FIG. 4. FIG. 4 is a flowchart for explaining some steps of FIG. 3 in more detail.

Referring to this drawing (and FIGS. 1 and 2), the source gas may maintain its molecular state in the processing area 115 (S11). For this purpose, the processing temperature may be maintained below a pyrolysis temperature of the source gas. In detail, the processing temperature of the ethylene gas or the propylene gas may be determined within a range of 400 °C to 600 °C. This temperature may be a relatively low temperature compared to a temperature of a thin film deposition processing.

The source gas may undergo the chemical reaction with the thin film in the molecular state (S13). This chemical reaction may be possible because the source gas is maintained in the molecular state by the processing temperature.

Carbon in the source gas may be absorbed into the thin film by the chemical reaction between the source gas and the thin film, specifically by the chemical absorption (S15) .

Carbon may permeate deeply into the thin film by a pressing force (S17). The pressing force may refer to a force generated by the processing pressure. To generate the pressing force, the processing pressure may be a pressure higher than the atmospheric pressure.

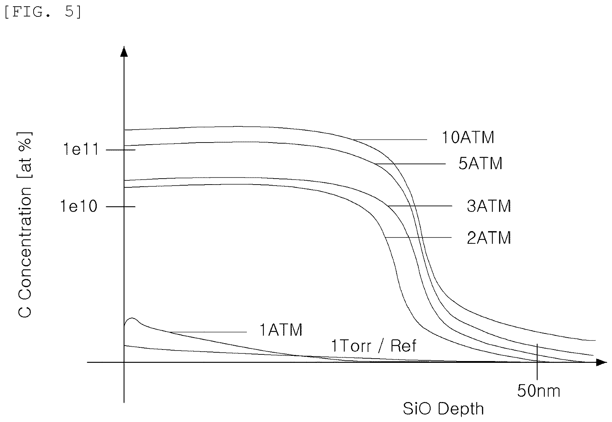

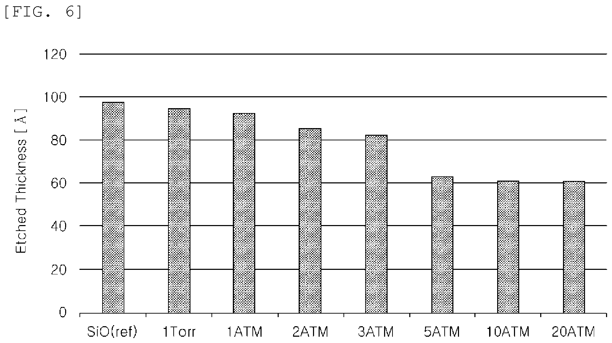

The description further describes a setting of the processing pressure with reference to FIGS. 5 and 6. FIG. 5 is a graph comparing carbon concentrations of the thin film doped by the method for doping carbon in a thin film on a wafer in FIG. 3, and FIG. 6 is a graph comparing wet etch depths of the thin film doped by the method for doping carbon in a thin film on a wafer in FIG. 3.

These graphs show results of an experiment in which the carbon doping is performed on a wafer on which a silicon dioxide film (SiO₂) is formed. In this experiment, the silicon dioxide film has a thickness of 50 nm. The ethylene (C₂H₄) gas is used as the source gas. The processing temperature is 400 °C. The processing pressure is adjusted within a range of 1 Torr to 20 ATM. A solution used for wet etching is a mixture of 1 part by weight of hydrofluoric acid per 100 parts by weight of pure water. The wet etching lasts for 100 seconds.

Referring to FIG. 5, the carbon concentration in the thin film may be insufficient when the processing pressure is at a level of 1 Torr and 1 ATM. A section where the carbon concentration is maintained at a constant level is also short. The reason is that a carbon doping effect is not significant.

On the other hand, when the processing pressure is 2 ATM or above, it may be seen that the carbon concentration is significantly increased compared to the case where the processing pressure is 1 ATM. When the processing pressure is 2 ATM, the carbon concentration is greatly higher than 1e^10, and reaches a significant level. When the processing pressure is 2 ATM, the section where the carbon concentration higher than 1e^10 is maintained becomes longer. The section where the carbon concentration higher than 1e^10 is maintained becomes longer as the processing pressure is increased to 5 ATM or 10 ATM. In particular, a section where oxygen concentration higher than 1e^11 exists when the processing pressure is 5 ATM or above.

Further referring to FIG. 6, when the processing pressure is 1 Torr and 1 ATM, a wet etch thickness is not much different from a (reference) case without the carbon doping.

On the other hand, it may be seen that the wet etch thickness is significantly reduced when the processing pressure is 2 ATM or above. In detail, when the processing pressure is 2 ATM, the wet etch thickness is noticeably reduced to reach a thickness of approximately 90% compared to a reference thickness.

As the processing pressure is increased, the wet etch thickness is further decreased. In detail, the wet etch thickness is about mid to high 60% compared to the reference thickness when the processing pressure is 5 ATM. The wet etch thickness may be reduced to about early 60% compared to the reference thickness when the processing pressure is 10 ATM or even 20 ATM.

In view of the carbon concentration and the wet etch thickness described above, the processing pressure of 2 ATM or higher significantly increases the carbon doping effect. The carbon doping effect becomes more powerful when the processing pressure is 5 ATM, or even 10 or 20 ATM.

The method for doping carbon in a thin film on a wafer as described above is not limited to the configuration and operation manner of the embodiments described above. The embodiments described above may be variously modified by selective combinations of all or some of the respective embodiments.

### [Industrial Applicability]

The present invention has potential industrial application in a field of doping carbon in a thin film on a wafer.

## Claims

1. A method for doping carbon in a thin film on a wafer, the method comprising:
disposing a thin film-formed wafer in a processing area;
supplying an atmospheric gas to the processing area to bring a pressure in the processing area to a processing pressure higher than atmospheric pressure;
heating the processing area to bring a temperature in the processing area to a processing temperature; and
supplying a source gas containing carbon to the processing area to allow the source gas to undergo a chemical reaction with the thin film at the processing pressure and the processing temperature, thereby doping the carbon in the thin film.

2. The method of claim 1, wherein the thin film includes any one of a silicon oxide film, a silicon nitride film, and a silicon nitride oxide film.

3. The method of claim 1, wherein the processing pressure is higher than 2 ATM.

4. The method of claim 1, wherein the processing pressure is a pressure determined within a range of 5 ATM to 20 ATM.

5. The method of claim 1, wherein the processing temperature is a temperature below a pyrolysis temperature of the source gas.

6. The method of claim 1, wherein the processing temperature is a temperature determined within a range of 400 °C to 600 °C.

7. The method of claim 1, wherein the source gas includes any one of ethylene gas and propylene gas.

8. The method of claim 1, wherein the atmospheric gas includes any one of hydrogen (H₂), deuterium (D₂), nitrogen (N₂), and argon (Ar) gases.

9. A method for doping carbon in a thin film on a wafer, the method comprising:
disposing a thin film-formed wafer in a processing area;
supplying a source gas containing carbon to the processing area;
allowing a source gas to undergo a chemical reaction with the thin film in a molecular state, thus causing carbon to be chemically absorbed to the thin film; and
allowing carbon to permeate into the thin film by a pressing force generated by the processing pressure.

10. The method of claim 9, wherein in the allowing of the source gas to undergo the chemical reaction with the thin film in the molecular state, thus causing carbon to be chemically absorbed to the thin film, a temperature in the processing area is maintained below a pyrolysis temperature of the source gas.

11. The method of claim 9, wherein in the allowing of the source gas to undergo the chemical reaction with the thin film in the molecular state, thus causing carbon to be chemically absorbed to the thin film, a temperature in the processing area is maintained within a range of 400 °C to 600 °C.

12. The method of claim 9, wherein in the allowing of carbon to permeate into the thin film by the pressing force generated by the processing pressure, the processing pressure is maintained to be higher than 2 ATM.

13. The method of claim 9, wherein in the allowing of carbon to permeate into the thin film by the pressing force generated by the processing pressure, the processing pressure is maintained within a range of 5 ATM to 20 ATM.
